# EUROPEAN PATENT SPECIFICATION

(11) **EP 0 471 412 B1**
(45) Date of publication and mention of the grant of the patent: **18.06.1997**
(21) Application number: 91202063.3
(22) Date of filing: 13.08.1991
(51) Int. Cl.: H04H 1/00, H03D 1/22

(54) **Receivers for frequency modulated transmissions**
Empfänger für frequenzmodulierte Übertragungen
Récepteurs pour transmissions en modulation de fréquence

(30) Priority: 15.08.1990 GB 9017894
(43) Date of publication of application: 19.02.1992
(73) Proprietor: Philips Electronics N.V., 5621 BA Eindhoven (NL)
(72) Inventor: Bucknell, Paul, Redhill, Surrey RH1 5HA (GB)
(74) Representative: Andrews, Arthur Stanley

(56) References cited:
- EP-A- 0 201 092
- EP-A- 0 374 996
- PATENT ABSTRACTS OF JAPAN vol. 13, no. 26 (E-706)20 January 1989 & JP-A-63 228 831
- PATENT ABSTRACTS OF JAPAN vol. 14, no. 368 (E-962)9 August 1990 & JP-A-21 32 922

## Description

The present invention relates to a receiver for the reception of frequency modulated transmissions which include a bi-phase encoded digital data signal which is double-sideband amplitude modulated on a suppressed carrier which carrier is additionally amplitude modulated by a two tone data signal, the modulation of the carrier by the digital data signal having a quadrature phase relationship with that by the two tone data signal, said receiver including a demodulator for demodulating said data signals modulated carrier when received, said demodulator comprising means for producing first and second baseband outputs from said received modulated carrier which outputs have a quadrature relationship and one of which forms the demodulator output for one of said data signals, first means for comparing the relative magnitudes of said first and second baseband outputs, means for low pass filtering the output of said comparing means which filtered output is applied to means for supplying quadrature related components to said means for producing said first and second baseband outputs to ensure the correct demodulation of said applied signal.

Such a receiver is described in published European Patent Application 0374996A which relates to an FM-receiver suitable for the reception and processing of digital signals in a Radio Data System (RDS). Details of RDS are given in the European Broadcasting Union document "Specification of the radio-data system RDS for VHF/FM sound broadcasting". EBU Tech. 3244, March 1984. The RDS information is transmitted as a bi-phase encoded data signal having a data rate of 1.1875 kbits/second which is double-sideband amplitude modulated on a 57 kHz sub-carrier which carrier is suppressed. An alternative auto traffic information system, Autofahrer Rundfunk Information (ARI) which predates RDS is still being broadcast in Austria, Germany, Luxembourg and Switzerland and in some areas RDS and ARI are broadcast simultaneously. The ARI signals consist of two tones, the lower of which lies in the range between 23 and 54Hz whilst the higher, which is not always present, is at 125Hz which tones are amplitude modulated on a 57kHz sub-carrier. Where ARI and RDS are transmitted simultaneously the EBU recommendation is that the phase angle between them is 90 degrees to reduce the possibility of the RDS signal amplitude modulating the ARI signal. The above European Patent Application employs a 57kHz notch filter positioned prior to the RDS demodulator which improves the sensitivity of the RDS demodulator in multi-path reception conditions when an ARI signal is present. However this filter also removes the ARI signal when present and thus it is necessary to take off the ARI signal prior to the notch filter and to provide a demodulator for the ARI signal which is separate to that used for the RDS signal.

Patent Abstracts of Japan, Vol 13, No 26 (E-706), 20th January 1989; Abstract of JP-A-63228831 (Sanyo) 22-09-1988 discloses an arrangement for demodulating RDS and ARI signals without using a band suppressing circuit for ARI signal.

It is an object of the invention to provide a novel construction of receiver for frequency modulated transmissions which incorporates a demodulator which makes use of both the digital and two tone data signals.

The invention provides a receiver for the reception of frequency modulated transmissions which include a bi-phase encoded digital data signal which is double-sideband amplitude modulated on a suppressed carrier which carrier is additionally amplitude modulated by a two tone data signal, the modulation of the carrier by the digital data signal having a quadrature phase relationship with that of the two tone data signal, said receiver including a demodulator for demodulating said data signals modulated carrier when received, said demodulator comprising means for producing first and second baseband outputs from said received modulated carrier which outputs have a quadrature relationship and one of which forms the demodulator output for one of said data signals, first means for comparing the relative magnitudes of said first and second baseband outputs, means for low pass filtering the output of said comparing means which filtered output is applied to means for supplying quadrature related components to said means for producing said first and second baseband outputs to ensure the correct demodulation of said applied signal, characterised in that said receiver additionally comprises second means for comparing the relative magnitudes of said first and second baseband outputs, and means for summing the outputs of said first and second comparing means such that said means for supplying said quadrature related components is subject to the control of both said first and second comparing means.

Such a receiver has the advantage that the performance of the demodulator is improved especially in the case of multipath reception whilst its locking-in time is reduced by using both the digital and two tone data signals.

Where one of the data signals has an amplitude greater than that of the other data signal, the invention may be further characterised in that the baseband outputs are applied to the first comparing means through means for substantially removing said one data signal. If the said one data signal is an auto traffic information (ARI) two tone data signal whilst the other data signal is a radio data system (RDS) digital data signal, each connection conveying the baseband outputs to the first comparing means may include a high pass filter for preventing the first comparing means from being influenced by the ARI data signal.

The means for producing baseband outputs may comprise a first stage for providing the first and second outputs substantially at baseband and a second stage for providing these outputs at baseband, the quadrature related components being supplied to the second stage for ensuring the correct phasing of the outputs. The second stage may comprise first, second, third and fourth mixer circuits and first and second summing circuits, the first output of the first stage being applied to a first input of the first and second mixer circuits whilst the second output of the first stage is applied to a first input of the third and fourth mixer circuits, a second input of the first and third mixer circuits receiving one of the quadrature related components the other component being applied to a second input of the second and fourth mixer circuits, the outputs of the first and fourth mixer circuits being summed by the first summing circuit to produce the first baseband output whilst the difference between the outputs of the second and third mixer circuits is produced by the second summing circuit to provide the second baseband output.

One input to the first and/or to the second comparing means may be by way of a loop gain control stage for controlling the amplitude of the signal applied thereto under the control of an applied scaling factor. The other input to the first and/or to the second comparing means may be by way of a limiter stage whose output may indicate the sign of the second output.

Where the digital data signal is an RDS signal this may be derived from one of the baseband outputs and applied to an RDS signal decoder. The invention also provides a demodulator for digital and for use in a

receiver for the reception of frequency modulated transmissions which include a bi-phase encoded digital data signal which is double-sideband amplitude modulated on a suppressed carrier which carrier is additionally amplitude modulated by a two tone data signal, the modulation of the carrier by the digital data signal having a quadrature phase relationship with that of the two tone data signal, said demodulator comprising means for producing first and second baseband outputs from said received modulated carrier which outputs have a quadrature relationship and one of which forms the demodulator output for one of said data signals, first means for comparing the relative magnitudes of said first and second baseband outputs, means for low pass filtering the output of said comparing means which filtered output is applied to means for supplying quadrature related components to said means for producing said first and second baseband outputs to ensure the correct demodulation of said applied signal, characterised in that said demodulator additionally comprises second means for comparing the relative magnitudes of said first and second baseband outputs, and means for summing the outputs of said first and second comparing means such that said means for supplying said quadrature related components is subject to the control of both said first and second comparing means.

The above and other features of the invention will now be described, by way of example, with reference to the accompanying drawings in which:-
Figure 1 is a block diagram of a receiver according to the invention,
Figure 2 is a more detailed diagram of selected parts of Figure 1,
Figure 3 is also a more detailed diagram of part of Figure 1, and
Figure 4 shows the combination of parts of Figure 2 and 3.

The VHF/FM receiver shown in Figure I has an input IP to which an aerial A can be connected to convey signals to the receiver. The receiver comprises a high frequency section HF which receives signals at VHF from input I in the band 88 to 108MHz and down converts this to an intermediate frequency which might suitably be 10.7MHz. The IF signal is applied to a frequency modulated detector FD to produce the L+R sound signal at baseband, the 19kHz pilot tone, the L-R sound signals amplitude modulated on a 38kHz subcarrier and the RDS and ARI signals modulated on a 57kHz subcarrier. These are all applied to an analogue-to-digital converter AD which performs amplitude sampling to produce a series of serial words at the sampling rate. Other forms of digital sampling could of course be used. The L+R, pilot tone and L-R subcarrier digitised components are processed in a stereo sound signal processor SP to produce at its outputs 01 and 02 respective left and right sound components for application to respective externally connected loudspeakers LSL and LSR.

The output from the converter AD is also applied to a first demodulation stage DM where the signal is down mixed to substantially baseband to produce quadrature phase related components I and Q. The resulting I and Q components are applied to a second demodulation stage EM in the form of an exponential multiplier acting as a frequency shifter which shifts the phase of the applied components by the quadrature phased outputs of an associated local oscillator LO to produce I and Q components which are truly at baseband. As the exponential multiplier EM does not produce double frequency components it is not necessary to low pass filter its I and Q outputs. These baseband outputs are applied to respective phase comparators C1 and C2 where the I and Q components are compared in phase and their outputs added in a summing stage S, the summed output being applied by way of a low pass loop filter LP to the local oscillator LO to control the phase of its outputs. The oscillator LO outputs are applied to the exponential multiplier EM to ensure correct phasing of its I and Q outputs. In areas where the RDS and ARI signals are both present the ARI signal is generally of a greater amplitude than the RDS signal. The RDS phase comparator C1 connections may therefore include filtering to prevent the ARI signal from swamping the RDS signal. Such filtering may take the form of a high pass filter in each input to comparator C1 which would remove the ARI signal as well as any noise which may also be present. If the RDS signal were greater than the ARI signal then the filtering could be associated with the ARI phase comparator C2 which could be conveneintly formed by a low pass filter in each input to comparator C2. The RDS signal output of this demodulator is derived from the I component output of the exponential multiplier EM which is additionally applied to an RDS decoder RD to recover the information conveyed by the RDS signal.

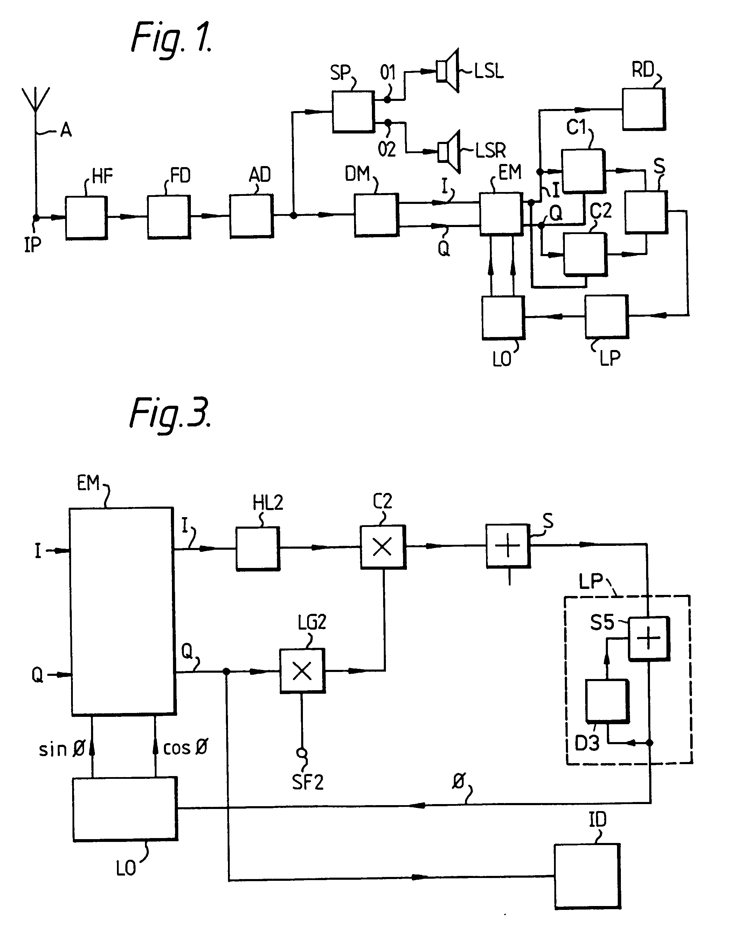

An ARI decoder is not included for the reasons given in relation to Figure 1. ARI decoder is not included in Figure 1 as it is intended that information carried by an ARI signal will be duplicated by the associated RDS signal, it being further intended that ARI signal transmissions will continue for some time to serve the receivers for these transmissions. Should an ARI decoder be required it could be connected to the Q output of the exponential multiplier EM. The provision of separate comparison loops for the two signals has the advantage that the locking time for the demodulator when the RDS and ARI signals are present simultaneously is quicker than if a comparison loop was only provided for one of the signals.

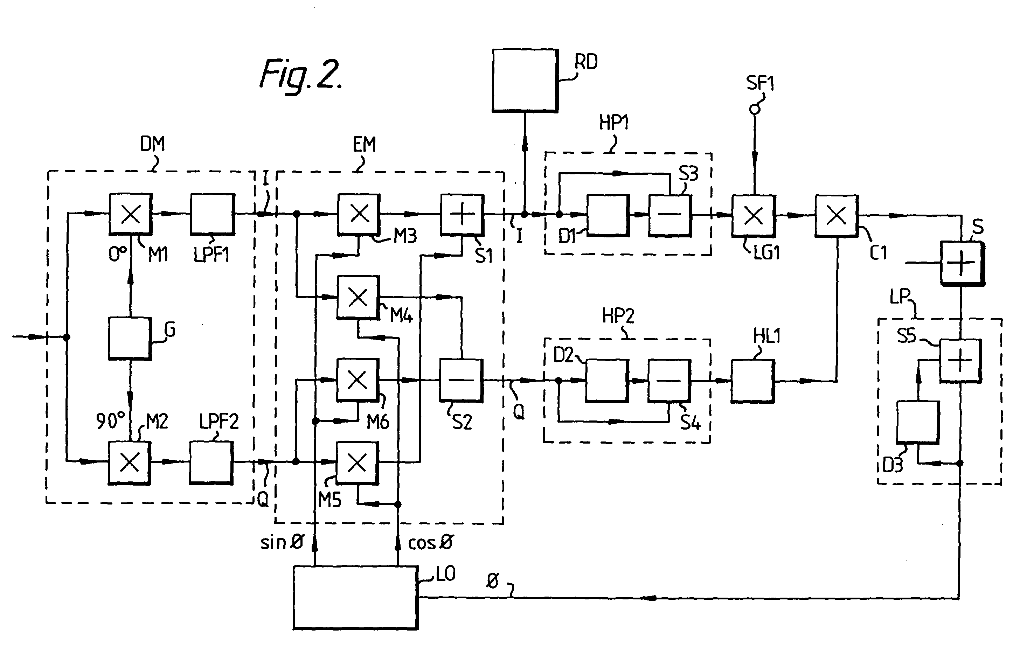

Figure 2 shows part of Figure 1 in greater detail, in relation to the RDS comparator, corresponding references between these two figures indicating like components. The down mixing stage DM comprises first and second mixer stages M1 and M2 each in the form of multipliers each of which at one input receives the digitally sampled 57kHz components from the analogue to digital converter (not shown). The other input of the stages M1 and M2 each receive oscillations from a 57kHz generator G, those for stage M1 being shifted by 90 degrees compared with those applied to stage M2. The outputs from the stages M1 and M2 are taken by way of respective low pass filter LPF1 and LPF2 which remove the sum mixing products and the stereo sound components whilst passing the quadrature related products I and Q at substantially baseband. The exponential multiplier EM which receives the I and O components comprises four further multiplier stages M3, M4, M5 and M6 with stages M3 and M4 receiving at their first input the I component from the down mixer DM whilst stages M5 and M6 receive the Q component at their first input. The second input of stages M3, M4, M5 and M6 each receive an input from the local oscillator LO that (sin φ) to stages M3 and M6 being in quadrature relationship to that (cos φ) to stages M4 and M5. A summing stage S1 receives and adds the outputs of stages M3 and M5 whilst an additional summing stage S2 receives and produces the difference between the outputs of stages M4 and M6. The outputs I and Q from the exponential multiplier EM truly at baseband are respectively derived from the outputs of summing stages S1 and S2.

Filtering of the RDS signal is provided by a high pass filter HP1 connected to the I baseband output and is formed by an arrangement having two input paths one of which is by way of a delay stage D1 having a delay time of one sample period, the delayed and undelayed paths being applied to respective inputs of a further summing stage S3 whose output is the difference between its inputs. A similar high pass filter HP2 connected to the Q baseband output is formed using delay stage D2 and summing stage S4. The output from filter HP1 is applied to the comparator C1, which in Figure 2 is formed by a further multiplier, by way of a loop gain control stage LG1 a control input of which receives via an input SF1 a preset scaling factor. The output from filter HP2, which as with the output from filter HP1 is in the form of a 6-bit word, is applied to comparator C1 by way of a hard limit stage HL1 which provides limiting of residual RDS signal prior to lock-in. In practice the limit stage HL1 selects only the sign bit from the 6-bit word applied to it so that the 6-bit word from loop gain control stage LG1 is compared with that sign bit. The output of comparator C1 is connected through summing stage S to the loop filter LP which is formed by a further summing stage S5 one input of which receives the result of the comparison whilst its other input receives the delayed summed output from stage S5, the delay being achieved by means of a delay stage D3 having a delay time of one sample period. In Figure 2 the local oscillator LO may take the form of a sine and cosine look-up table which provides quadrature related outputs to the exponential multiplier EM in response to the 6-bit words applied to it. Each input to comparator C2. The components EM, HP1, HP2, C1, LP and LO form a modified "Costas Loop" demodulator, this type of demodulator being described in Proceedings of the IRE, December 1956, pages 1713 to 1718, "Synchronous Communications" by John P. Costas.

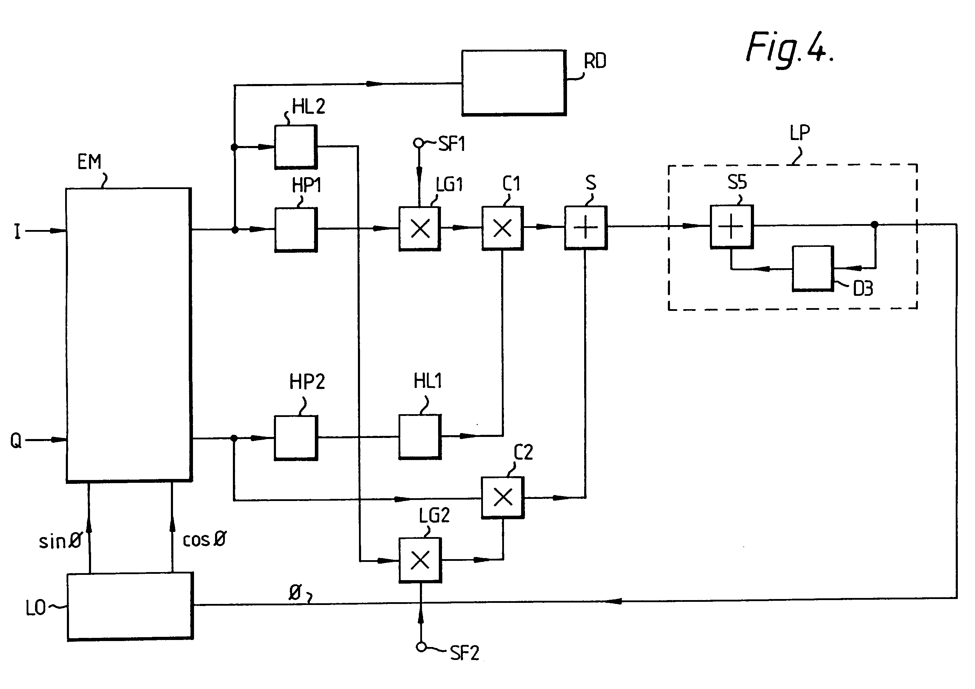

Where it is required to receive the ARI signal it will be necessary to provide means to demodulate and decode such a signal and Figure 3 shows part of Figure 1 in relation to the ARI comparator in greater detail together with an ARI decoder, components employing like references in this figure and Figures 1 and 2 indicating like components and will not be further described. In Figure 3 the I component from the exponential multiplier EM is hard limited by limiter stage HL2 to provide, as with limiter stage HL1, the sign bit of each serial word of the I component which normally carries the RDS signal. This sign bit is applied to comparator C2, also in the form of a multiplier, a second input of which receives the Q component by way of a loop gain control stage LG2 similar to that of stage LG1. The control input of stage LG2 receives a preset scaling factor from an input SF2. The output of comparator C2 is applied to the local oscillator LO via the summing stage S and the loop filter LP as before. The demodulated ARI signal is derived from the Q component which is also applied to an ARI decoder ID to recover the information conveyed by ARI signals.

Figure 4 shows a combination of stages from Figures 2 and 3 to provide decoding for RDS signal and corresponding components in these figures using the same references indicate like components. An ARI decoder is not included for the reasons given in relation to Figure 1. Each portion of Figure 4 operates in the manner described in relation to Figures 2 and 3 with summing stage S adding the outputs of the two comparators C1 and C2 prior to application to the local oscillator LO via the loop filter LP. A number of common stages are used in the processing of both the RDS and ARI signals.

In the above description the processing of the ARI and RDS signals is shown to be carried out following their conversion into digitally sampled signals and various known methods of performing digital sampling may be employed. Some of the processing stages have been described in terms more usually employed for analogue signal processing though it will be realised that they are performed by digital techniques and some might even be performed by the software control of a microprocessor. Although the above description is concerned with processing digitally sampled signals it will be appreciated that analogue processing could alternatively be used though it might prove more complex, and this would require the removal of the analogue-to-digital converter AD shown in Figure 1.

From reading the present disclosure, other modifications will be apparent to persons skilled in the art. Such modifications may involve other features which are already known in the design, manufacture and use of FM receivers and component parts thereof and which may be used instead of or in addition to features already described herein.

## Claims

1. A receiver for the reception of frequency modulated transmissions which include a bi-phase encoded digital data signal which is double-sideband amplitude modulated on a suppressed carrier which carrier is additionally amplitude modulated by a two tone data signal, the modulation of the carrier by the digital data signal having a quadrature phase relationship with that of the two tone data signal, said receiver including a demodulator for demodulating said data signals modulated carrier when received, said demodulator comprising means for producing first and second baseband outputs from said received modulated carrier which outputs have a quadrature relationship and one of which forms the demodulator output for one of said data signals, first means for comparing the relative magnitudes of said first and second baseband outputs, means for low pass filtering the output of said comparing means which filtered output is applied to means for supplying quadrature related components to said means for producing said first and second baseband outputs to ensure the correct demodulation of said applied signal, characterised in that said receiver additionally comprises second means for comparing the relative magnitudes of said first and second baseband outputs, and means for summing the outputs of said first and second comparing means such that said means for supplying said quadrature related components is subject to the control of both said first and second comparing means.

2. A receiver as claimed in Claim 1, in which one of said data signals has an amplitude greater than that of the other data signal, characterised in that the said baseband outputs are applied to said first comparing means through means for substantially removing said one data signal.

3. A receiver as claimed in Claim 2, in which said one data signal is an auto traffic information (ARI) two tone data signal whilst the other data signal is a radio data system (RDS) digital data signal, characterised in that each connection conveying said baseband outputs to said first comparing means includes a high pass filter for preventing the first comparing means from being influenced by said ARI data signal.

4. A receiver as claimed in Claim 1, 2 or 3, characterised in that said means for producing baseband outputs comprises a first stage for providing said first and second outputs substantially at baseband and a second stage for providing these outputs at baseband, said quadrature related components being supplied to said second stage for ensuring the correct phasing of said outputs.

5. A receiver as claimed in Claim 4, characterised in that said second stage comprises first, second, third and fourth mixer circuits and first and second summing circuits, the first output of said first stage being applied to a first input of said first and second mixer circuits whilst the second output of said first stage is applied to a first input of said third and fourth mixer circuits, a second input of said first and third mixer circuits receiving one of said quadrature related components the other component being applied to a second input of said second and fourth mixer circuits, the outputs of said first and fourth mixer circuits being summed by said first summing circuit to produce said first baseband output whilst the difference between the outputs of said second and third mixer circuits is produced by said second summing circuit to provide said second baseband output.

6. A receiver as claimed in Claim 1, 2, 3, 4 or 5, characterised in that one input to said first and/or to said second comparing means is by way of a loop gain control stage for controlling the amplitude of the signal applied thereto under the control of an applied scaling factor.

7. A receiver as claimed in Claim 6, characterised in that the other input to said first and/or to said second comparing means is by way of a limiter stage.

8. A receiver as claimed in Claim 7, characterised in that the output of said limiter stage indicates the sign of the said second output.

9. A receiver as claimed in Claim 3, characterised in that said RDS signal is derived from one of said baseband outputs and applied to an RDS signal decoder.

10. A demodulator for use in a receiver for the reception of frequency modulated transmissions which include a bi-phase encoded digital data signal which is double-sideband amplitude modulated on a suppressed carrier which carrier is additionally amplitude modulated by a two tone data signal, the modulation of the carrier by the digital data signal having a quadrature phase relationship with that of the two tone data signal, said demodulator comprising means for producing first and second baseband outputs from said received modulated carrier which outputs have a quadrature relationship and one of which forms the demodulator output for one of said data signals, first means for comparing the relative magnitudes of said first and second baseband outputs, means for low pass filtering the output of said comparing means which filtered output is applied to means for supplying quadrature related components to said means for producing said first and second baseband outputs to ensure the correct demodulation of said applied signal, characterised in that said demodulator additionally comprises second means for comparing the relative magnitudes of said first and second baseband outputs, and means for summing the outputs of said first and second comparing means such that said means for supplying said quadrature related components is subject to the control of both said first and second comparing means.

## Patentansprüche

1. Ein Empfänger zum Empfang frequenzmodulierter Übertragungen, die ein zweiphasig codiertes digitales Datensignal enthalten, das auf einen unterdrückten Träger zweiseitenband-amplitudenmoduliert ist, wobei der Träger zudem mit einem Zweitonsignal moduliert und die Modulation des Trägers mit dem digitalen Datensignal gegenüber derjenigen mit dem Zweiton-Datensignal um 90° verschoben ist, wobei der besagte Empfänger einen Demodulator zum Demodulieren des besagten, mit den besagten Datensignalen modulierten Trägers beim Empfang und der besagte Demodulator eine Vorrichtung zum Erzeugen eines ersten und eines zweiten BasisbandAusgangs aus dem besagten, empfangenen modulierten Träger hat, während diese Ausgänge gegeneinander um 90° verschoben sind und einer von ihnen der Demodulatorausgang für eines der besagten Datensignale ist, sowie eine erste Vorrichtung zum Vergleichen der relativen Größe des besagten ersten und zweiten Basisbandausgangs, eine Vorrichtung zum Tiefpaßfiltern des Ausgangs der besagten Vergleichsvorrichtung, wobei der gefilterte Ausgang in eine Vorrichtung eingespeist wird, die um 90° gegeneinander verschobene Komponenten für die besagte Vorrichtung zum Erzeugen eines ersten und zweiten Basisbandausgangs liefert, um eine korrekte Demodulation des besagten eingespeisten Signals sicherzustellen, der dadurch gekennzeichnet ist, daß der besagte Empfänger zusätzlich eine zweite Vorrichtung zum Vergleichen der relativen Größe des besagten ersten und zweiten Basisbandausgangs hat sowie eine Vorrichtung zum Addieren der Ausgänge der besagten ersten und zweiten Vergleichsvorrichtung, so daß die besagte Vorrichtung zum Erzeugen von um 90° gegeneinander verschobenen Komponenten zugleich von der besagten ersten und der besagten zweiten Vergleichsvorrichtungen gesteuert wird.

2. Ein Empfänger laut in Anspruch 1, bei dem eines der besagten Datensignale eine größere Amplitude als das andere Datensignal hat, dadurch gekennzeichnet, daß die besagten Basisbandausgänge in die besagte erste Vergleichsvorrichtung über eine Vorrichtung zum Entfernen des wesentlichen Teils des besagten einen Datensignals eingespeist wird.

3. Ein Empfänger laut in Anspruch 2, bei dem das eine besagte Datensignal eine Verkehrsinformation (ARI) in Form eines Zweiton-Datensignals ist, während das andere Datensignal ein Radiodatensystem (RDS) in Form eines digitales Datensignals ist, dadurch gekennzeichnet, daß jede Verbindung, die die besagten Basisbandausgänge mit der besagten ersten Vergleichsvorrichtung verbindet, einen Hochpaßfilter enthält um zu verhindern, daß die erste Vergleichsvorrichtung vom besagten ARI-Datensignal beeinflußt wird.

4. Ein Empfänger laut den Ansprüchen 1, 2 oder 3, dadurch gekennzeichnet, daß die besagte Vorrichtung zum Erzeugen von Basisbandausgängen eine erste Stufe zum Liefern des besagten ersten und zweiten Ausgangs im wesentlichen im Basisband und eine zweite Stufe zum Liefern dieser Ausgänge im Basisband umfaßt, wobei die besagten, gegeneineander um 90° verschobenen Komponenten in die besagte korrekte zweite Stufe eingespeist werden, um eine korrekte Phase der besagten Ausgänge zu sichern.

5. Ein Empfänger laut in Anspruch 4, dadurch gekennzeichnet, daß die besagte zweite Stufe einen ersten, zweiten, dritten und vierten Mischkreis und einen ersten und zweiten Addierkreis umfaßt, wobei der erste Ausgang der besagten ersten Stufe in einen ersten Eingang des besagten ersten und zweiten Mischkreises gespeist wird, während der zweite Ausgang der besagten ersten Stufe in einen ersten Eingang des besagten dritten und vierten Mischkreises gespeist wird, ein zweiter Eingang des besagten ersten und dritten Mischkreises eine der besagten, um 90° gegeneinander verschobenen Komponenten empfängt, während die andere Komponente in einen zweiten Eingang des besagten zweiten und vierten Mischkreises gespeist wird, wobei die Ausgänge des besagten ersten und vierten Mischkreises vom besagten ersten Addierkreis addiert werden und den besagten ersten Basisbandausgang erzeugen, während die Differenz zwischen den Ausgängen des besagten zweiten und dritten Mischkreises vom besagten zweiten Addierkreis erzeugt wird und den besagten zweiten Basisbandausgang liefert.

6. Ein Empfänger laut den Ansprüchen 1, 2, 3, 4 oder 5, dadurch gekennzeichnet, daß ein Eingang zur besagten ersten und/oder zur besagten zweiten Vergleichsvorrichtung über eine Schleifenverstärkungs-Steuerstufe verläuft, die die Amplitude des eingespeisten Signals und gesteuert von einem eingespeisten Skalenfaktor steuert.

7. Ein Empfänger laut Anspruch 6, dadurch gekennzeichnet, daß der andere Eingang der besagten ersten und/oder der besagten zweiten Vergleichsvorrichtung über eine Begrenzungsstufe verläuft.

8. Ein Empfänger laut Anspruch 7, dadurch gekennzeichnet, daß der Ausgang der besagten Begrenzungsstufe das Vorzeichen des besagten zweiten Ausgangs angibt.

9. Ein Empfänger laut Anspruch 3, dadurch gekennzeichnet, daß das RDS-Signal von einem der besagten Basisbandausgänge abgeleitet wird und in einen RDS-Signaldecodierer eingespeist wird.

10. Ein Demodulator zur Anwendung in einem Empfänger für den Empfang frequenzmodulierter Übertragungen, die ein zweiphasig codiertes digitales Datensignal enthalten, das auf einen unterdrückten Träger zweiseitenband-amplitudenmoduliert ist, wobei der Träger außerdem mit einem Zweitonsignal amplitudenmoduliert ist, die Modulation des Trägers mit dem digitalen Datensignal gegenüber derjenigen mit dem Zweiton-Datensignal um 90° verschoben ist, wobei der besagte Demodulator eine Vorrichtung zum Erzeugen eines ersten und zweiten Basisbandausgangs aus dem besagten empfangenen, modulierten Träger enthält und diese Ausgänge um 90° gegeneinander verschoben sind und einer von ihnen der Demodulatorausgang für eines der besagten Datensignale ist, sowie eine erste Vorrichtung zum Vergleichen der relativen Größe des besagten ersten und zweiten Basisbandausgangs, und eine Vorrichtung zum Tiefpaßfiltern des Ausgangs der besagten Vergleichsvorrichtung, während der gefilterte Ausgang in eine Vorrichtung zum Erzeugen von um 90° gegeneinander verschobenen Komponenten für die besagte Vorrichtung zum Erzeugen des besagten ersten und zweiten Basisbandausgangs gespeist wird, um eine korrekte Demodulation des besagten eingespeisten Signals zu sichern, dadurch gekennzeichnet, daß der besagte Demodulator zusätzlich eine zweite Vorrichtung zum Vergleichen der relativen Größe des besagten ersten und zweiten Basisbandausgangs und eine Vorrichtung zum Addieren der Ausgänge der besagten ersten und zweiten Vergleichsvorrichtung hat, so daß die besagte Vorrichtung zum Erzeugen der besagten, um 90° gegeneinander verschobenen Komponenten, von zugleich von der besagten ersten und der besagten zweiten Vergleichsvorrichtungen gesteuert wird.

## Revendications

1. Récepteur pour la réception d'émissions modulées en fréquence qui comprennent un signal de données numérique à modulation de phase à deux états qui est un signal à modulation d'amplitude à deux bandes latérales sur une porteuse supprimée laquelle porteuse est en outre modulée en amplitude par un signal de données à deux fréquences porteuses, la modulation de la porteuse par le signal de données numérique présentant une relation de phase en quadrature avec la modulation de la porteuse par le signal de données à deux fréquences porteuses, ledit récepteur comprenant un démodulateur pour démoduler ladite porteuse modulée par des signaux de données lorsqu'elle est reçue, ledit démodulateur comprenant un moyen pour produire des première et deuxième sorties en bande de base à partir de ladite porteuse modulée reçue, lesdites sorties ayant une relation en quadrature et l'une de ces sorties constituant la sortie du démodulateur pour un desdits signaux de données, un premier moyen pour comparer les amplitudes relatives desdites première et deuxième sorties en bande de base, un moyen pour soumettre à un filtrage passe-bas la sortie dudit moyen comparateur, laquelle sortie filtrée est appliquée à un moyen qui délivre des composantes en quadrature audit moyen censé produire lesdites première et deuxième sorties en bande de base pour assurer la démodulation correcte dudit signal appliqué, caractérisé en ce que ledit récepteur comprend en plus un deuxième moyen pour comparer les amplitudes relatives desdites première et deuxième sorties en bande de base, et un moyen pour sommer les sorties desdits premier et deuxième moyens comparateurs, de telle sorte que ledit moyen censé fournir lesdites composantes en quadrature soit soumis au contrôle des deux dits premier et deuxième moyens comparateurs.

2. Récepteur suivant la revendication 1, dans lequel un premier desdits signaux de données a une amplitude plus grande que celle de l'autre signal de données, caractérisé en ce que lesdites sorties en bande de base sont appliquées audit premier moyen comparateur via un moyen destiné à éliminer sensiblement ledit premier signal de données.

3. Récepteur suivant la revendication 2, dans lequel ledit premier signal de données est un signal de données à deux fréquences porteuses d'information routière (ARI), tandis que l'autre signal de données est un signal de données numérique du système RDS (Radio Data System), caractérisé en ce que chaque connexion acheminant lesdites sorties en bande de base jusqu'audit moyen comparateur comprend un filtre passe-haut destiné à empêcher que le premier moyen comparateur d'être influencé par ledit signal de données ARI.

4. Récepteur suivant la revendication 1, 2 ou 3, caractérisé en ce que ledit moyen destiné à produire des sorties en bande de base comprend un premier étage pour fournir lesdites première et deuxième sorties sensiblement en bande de base et un deuxième étage pour fournir ces sorties en bande de base, lesdites composantes en quadrature étant fournies audit deuxième étage pour assurer la mise en phase correcte desdites sorties.

5. Récepteur suivant la revendication 4, caractérisé en ce que ledit deuxième étage comprend un premier, un deuxième, un troisième et un quatrième circuits mélangeurs et un premier et un deuxième circuits sommateurs, la première sortie du premier étage étant appliquée à une première entrée desdits premier et deuxième circuits mélangeurs, tandis que la deuxième sortie dudit premier étage est appliquée à une première entrée desdits troisième et quatrième circuits mélangeurs, une deuxième entrée desdits premier et troisième circuits mélangeurs recevant une desdites composantes en quadrature, l'autre composante étant appliquée à une deuxième entrée desdits deuxième et quatrième circuits mélangeurs, les sorties desdits premier et quatrième circuits mélangeurs étant sommées par ledit premier circuit sommateur afin de produire ladite première sortie en bande de base, tandis que la différence entre les sorties desdits deuxième et troisième circuits mélangeurs est produite par ledit deuxième circuit sommateur afin de fournir ladite deuxième sortie en bande de base.

6. Récepteur suivant la revendication 1, 2, 3, 4 ou 5, caractérisé en ce qu'une entrée audit premier et/ou audit deuxième moyens comparateurs passe par l'intermédiaire d'un étage de commande de gain de boucle pour commander l'amplitude du signal qui y est appliqué sous la commande d'un facteur d'échelle appliqué.

7. Récepteur suivant la revendication 6, caractérisé en ce que l'autre entrée audit premier et/ou audit deuxième moyens comparateurs passe par l'intermédiaire d'un étage limiteur.

8. Récepteur suivant la revendication 7, caractérisé en ce que la sortie dudit étage limiteur indique le signe de ladite deuxième sortie.

9. Récepteur suivant la revendication 3, caractérisé en ce que ledit signal RDS est dérivé d'une desdites sorties en bande de base et appliqué à un décodeur de signaux RDS.

10. Démodulateur à utiliser dans un récepteur pour la réception d'émissions, modulées en fréquence qui comprennent un signal de données numériques à modulation de phase à deux états qui est un signal à modulation d'amplitude à deux bandes latérales sur une porteuse supprimée, laquelle porteuse est en outre modulée en amplitude par un signal de données à deux fréquences porteuses, la modulation de la porteuse par le signal de données numériques présentant une relation de phase en quadrature avec celle du signal de données à deux fréquences porteuses, ledit démodulateur comprenant un moyen pour produire des première et deuxième sorties en bande de base à partir de ladite porteuse modulée reçue, lesdites sorties ayant une relation en quadrature et l'une de ces sorties constituant la sortie du démodulateur pour un desdits signaux de données, un premier moyen pour comparer les amplitudes relatives desdites première et deuxième sorties en bande de base, un moyen pour soumettre à un filtrage passe-bas la sortie dudit moyen comparateur, ladite sortie filtrée étant appliquée à un moyen qui délivre des composantes en quadrature audit moyen censé produire lesdites première et deuxième sorties en bande de base pour assurer la démodulation correcte dudit signal appliqué, caractérisé en ce que le démodulateur comprend en outre un deuxième moyen pour comparer les amplitudes relatives desdites première et deuxième sorties en bande de base, et un moyen pour sommer les sorties desdits premier et deuxième moyens comparateurs, de telle sorte que ledit moyen censé fournir lesdites composantes en quadrature soit soumis au contrôle des deux dits premier et deuxième moyens comparateurs.
